# EUROPEAN PATENT SPECIFICATION

(11) **EP 2 975 415 B1**
(45) Date of publication and mention of the grant of the patent: **16.04.2025**
(21) Application number: 13878429.3
(22) Date of filing: 15.03.2013
(51) Int. Cl.: G01R 19/00, G01R 19/25, H03M 1/12, H03H 17/06

(54) **MERGING UNIT FOR COLLECTING ELECTRICAL POWER SYSTEM INFORMATION**
ZUSAMMENFÜHRUNGSEINHEIT ZUM SAMMELN VON STROMSYSTEMINFORMATIONEN
UNITÉ DE FUSION PERMETTANT DE COLLECTER DES INFORMATIONS DE RÉSEAU ÉLECTRIQUE

(43) Date of publication of application: 20.01.2016
(73) Proprietor: Mitsubishi Electric Corporation, Tokyo 100-8310 (JP)
(72) Inventor: ODA, Shigetoo, Tokyo 100-8310 (JP)
(74) Representative: Mewburn Ellis LLP
(86) International application number: PCT/JP2013/057393
(87) International publication number: WO 2014/141464

(56) References cited:
- JP-A- H04 172 825
- JP-A- H05 346 443
- JP-A- H11 191 724
- US-A- 5 126 737
- US-A- 5 657 261
- US-A- 5 899 960
- US-A1- 2009 012 728
- CROCHIERE R E ET AL: "INTERPOLATION AND DECIMATION OF DIGITAL SIGNALS - A TUTORIAL REVIEW", PROCEEDINGS OF THE IEEE, IEEE. NEW YORK, US, vol. 69, no. 3, 1 March 1981 (1981-03-01), pages 300 - 321, XP002022466, ISSN: 0018-9219

## Description

### TITLE OF INVENTION

Merging Unit Which Collects Information of Power System TECHNICAL FIELD

The present invention relates to a merging unit which collects information of at least current or voltage from a power system.

### BACKGROUND ART

A protection relay device is used to collect information of such as current or voltage from a power system, and to detect a failure when it occurs in the power system or power equipment and separate the failure from the power system.

There is known a merging unit having a function of recording a signal waveform to be monitored (log function), when it is determined in such a protection relay device that a certain failure has occurred on a power system to be protected, over a prescribed period including timing at which such determination is made.

Serial data from the merging unit are transmitted to an IED (Intelligent Electronic Device) as a computation device, for data processing. The communication standard for this data transmission is defined by IEC61850-9-2. However, since this regulation is not organized enough to allow interconnection between a merging unit and an IED even if they are manufactured by different manufacturers, NPD 1 (IEC61850-9-2LE) has been proposed as a guideline regulation for interconnection. In that regulation, a sampling frequency which is 80 times the system frequency (80f) is defined for an IED for protection control, and a sampling frequency which is 256 times the system frequency (256f) is defined for an IED for recording system accident waveforms.

Accordingly, in a substation, a merging unit with a sample rate of 80f should be installed for protecting the power system, and a merging unit with a sample rate of 256f should be installed for recording accident waveforms.

An alternative possible method is to transmit data with a sample rate of 256f in a merging unit, and decimate received data at an IED on a receiving side. However, since 256f is not an integral multiple of 80f, it is not possible to obtain data for 80f by decimation. As a method for implementation, it is necessary to perform conversion from a sampling frequency of 256f to a sampling frequency of 80f. For example, as a technique for conversion from sample rate "A" to sample rate "B", in PTD 1 (Japanese

Patent Laying-Open No. 2010-130185, paragraph 0004), sample rate "A" is up-converted by inserting zero values in the least common multiple of "A" and "B", thereafter is processed by an integrator, and then is decimated to sample rate "B".

### CITATION LIST

### PATENT DOCUMENT

PTD 1: Japanese Patent Laying-Open No. 2010-130185, paragraph 0004
US 2009/012728 A1 proposes a system and method for multi-rate concurrent waveform capture and storage for power quality metering
US 5657261 A proposes interpolation of digital signals using signal sample replication

### NON PATENT DOCUMENT

NPD 1: IMPRLEMENTATION GUIDELINE FOR DIGITAL INTERFACE TO INSTRUMENT TRANSFORMERS USING IEC61850-9-2, UCA International Users Group, 2004-07-07, Table 10

### SUMMARY OF INVENTION

### TECHNICAL PROBLEM

When one IED for recording accidents attempts to receive serial data transmitted from a plurality of merging units within a substation for recording accident waveforms, there are possibilities that the attempt results in huge computation processing and memory capacity for processing and recording a plurality of data with a sample rate of 256f, and that the attempt results in an increased computation amount to perform sample rate conversion as described above in an IED for protection control, posing a problem in protection control function computation. That is, a conventional system has the following problems:
(1) In order to provide data to an IED for protection control or an IED for recording system accidents, it is necessary to install two types of merging units which perform sampling at 80f and 256f in a substation, which is costly; (2) Since a large amount of data is transferred from a plurality of merging units for 256f to one IED for recording accidents, it is necessary to increase transmission speed and improve processing ability of the IED.

The present invention has been made to solve the aforementioned problems, and one object of the present invention is to provide a merging unit capable of sampling data at different sample rates.

### SOLUTION TO PROBLEM

In accordance with an aspect of the present invention, a merging unit is provided as set forth in claims 1 and 2. A protection control system is provided as set forth in claim 3.

### ADVANTAGEOUS EFFECTS OF INVENTION

According to the present invention, data can be sampled at different sample rates, by an identical merging unit.

### BRIEF DESCRIPTION OF DRAWINGS

Fig. 1 is a schematic view showing an overall configuration of a protection control system including a merging unit in accordance with Embodiment 1 of the present invention.
Fig. 2 is a configuration diagram of the merging unit in accordance with Embodiment 1 of the present invention.
Fig. 3 is a block diagram of a sample rate conversion processing circuit in accordance with Embodiment 1 of the present invention.
Fig. 4 is a view for illustrating sample rate conversion processing in accordance with Embodiment 1 of the present invention.
Fig. 5 is a block configuration diagram of a second memory circuit in accordance with Embodiment 1 of the present invention.
Fig. 6 is a timing chart for illustrating an operation of the second memory circuit of Fig. 5.
Fig. 7 is a configuration diagram of a merging unit in accordance with Reference example 1 not encompassed by the wording of the claims but useful in understanding the present disclosure.

### DESCRIPTION OF EMBODIMENTS

Embodiments of the present invention will be described in detail with reference to the drawings. It is noted that identical or corresponding parts in the drawings will be designated by the same reference numerals, and the description thereof will not be repeated.

### [Embodiment 1]

First, an overall configuration of a protection control system including a merging unit (abbreviated as "MU" in the drawings) 4 in accordance with the present embodiment will be described.

### (System Configuration)

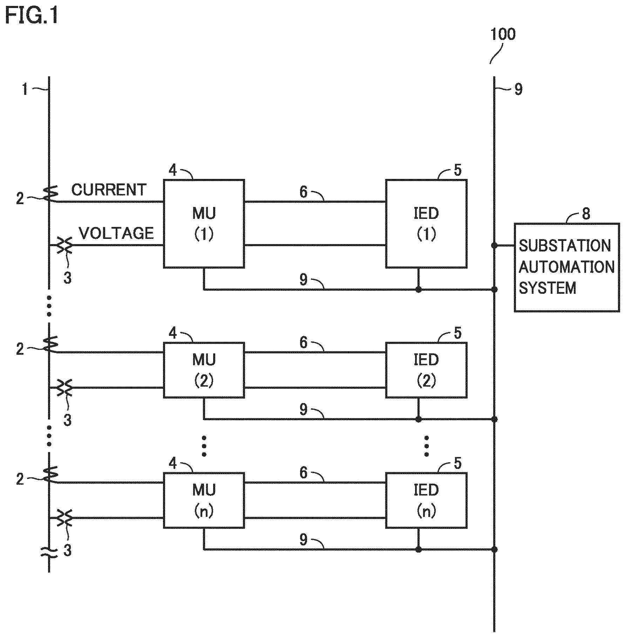

Fig. 1 is a schematic view showing an overall configuration of a protection control system including a merging unit in accordance with an embodiment of the present invention. Referring to Fig. 1, a protection control system 100 is provided in a substation, a power distribution station, and the like, to collect information of a power system, and to perform processing such as protection, control, monitoring, and the like of the power system based on the collected information. More specifically, protection control system 100 includes a plurality of merging units 4 which collect information of such as current or voltage from the power system, a plurality of computation devices (Intelligent Electronic Devices: hereinafter also referred to as "IEDs") 5 for performing protection, control, and monitoring of the power system, as external devices connected to merging units 4, and a substation automation system (SAS) 8 which collects information from IEDs 5 and the like. IEDs 5 are connected to respective corresponding merging units 4. It is noted that, although IEDs 5 are connected to corresponding merging units 4 in this drawing, a plurality of merging units may be connected to one IED, or one merging unit may be connected to a plurality of IEDs. In a typical protection control system, a plurality of IEDs 5 are arranged according to application (for example, for respective protection targets or control targets). In addition, the IEDs according to application include, for example, an IED for protection control which implements a protection control function, an IED for recording system accidents, and the like, aside from IEDs different for respective protection targets.

Fig. 1 shows, as an example of power equipment, a power line 1 equivalent to an electric power transmission line or a bus, and current transformers 2 and voltage transformers 3 connected to power line 1. Merging unit 4 and IED 5 can mutually communicate data therebetween, via a process bus 6 according to a prescribed protocol. Although process bus 6 may be configured to transmit data by electric signals, process bus 6 is configured in the present embodiment to transmit serial data by light signals using an optical fiber.

Merging unit 4 receives information required to protect and control the power system, such as information of respective three phases, from current transformer 2 and voltage transformer 3, collects (merges) the received information, and thereafter outputs the collected information to IED 5 via process bus 6. In addition, merging unit 4 has a function of receiving analog signals as current and voltage waveforms from current transformer 2 and voltage transformer 3, sampling the received signals, and thereby converting the received signals to digital data and outputting the digital data. Merging unit 4 generates a sampling signal, based on a time synchronization signal 7 received from IED 5 or an external time synchronization signal generator (not shown). A sample rate (or a sampling cycle) is determined by the frequency of the sampling signal.

Further, merging units 4, IEDs 5, and substation automation system 8 at a higher level are connected by a station bus 9, such that they can communicate with one another via station bus 9. IED 5 can also output the state of the power system in real time. For example, IED 5 can also output information of the power system to substation automation system 8 via station bus 9. Substation automation system 8 monitors IED 5 or merging unit 4 based on the information received via station bus 9. In addition, the plurality of IEDs 5 connected via station bus 9 can communicate with one another.

IED 5 performs processing such as protection, control, monitoring, and the like of the power system, based on the information from merging unit 4. For example, IED 5 determines, at every prescribed cycle, whether or not a predetermined relay computation logic for detecting an abnormality in the power system is satisfied. Further, if the relay computation logic is satisfied, IED 5 outputs a trip signal to a corresponding breaker (not shown), and transmits an accident detection signal to station bus 9.

IED 5 obtains, from a timer not shown, time data indicating a time at which the relay computation logic is satisfied, that is, time data indicating a time at which an abnormality such as a power system accident is detected, and transmits the accident detection signal with the time data attached thereto, via station bus 9. Merging unit 4 receives the accident detection signal from IED 5, as a trigger signal 10.

### (Configuration of Merging Unit)

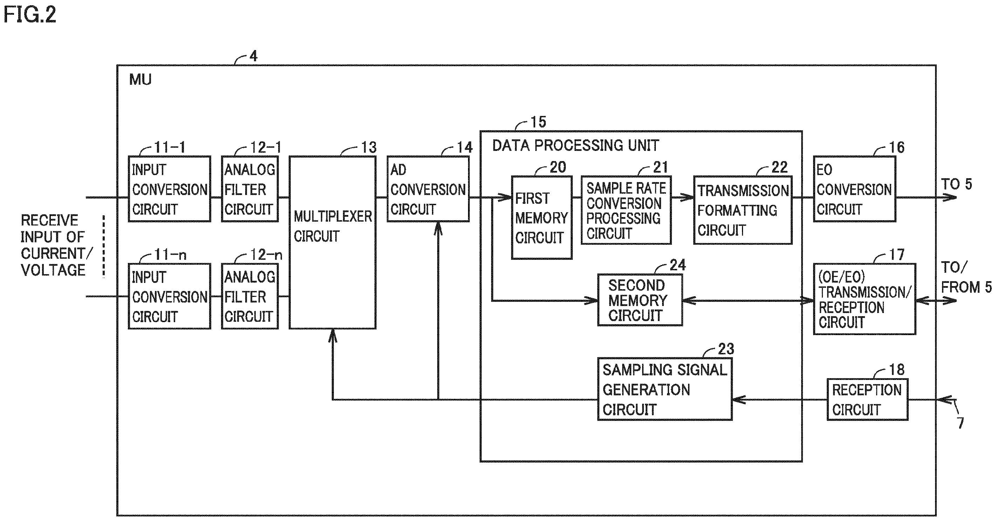

Fig. 2 is a configuration diagram of the merging unit in accordance with Embodiment 1 of the present invention. Merging unit 4 of Fig. 2 includes an input processing unit which converts an analog signal of a current waveform or a voltage waveform from current transformer 2 or voltage transformer 3 of the power system to digital data and outputs the digital data, a data processing unit 15, and a communication unit for transmitting and receiving data and signals to and from corresponding IED 5 or the like. Data processing unit 15 processes the digital data of the current waveform or the voltage waveform from the input processing unit to perform signal processing on data indicating the state of the power system according to the prescribed protocol, and outputs the processed data.

The input processing unit includes a plurality of input conversion circuits 11 (11-1 to 11-n, where "n" is the number of channels in the input conversion circuits) having a function of insulating merging unit 4 from an external circuit and performing voltage conversion, analog filter circuits 12 (12-1 to 12-n) corresponding to respective input conversion circuits 11, a multiplexer circuit 13 which receives signals from respective analog filter circuits 12 and guides the signals to an output side while switching them, and an AD (Analog to Digital) conversion circuit 14 which converts an analog signal from multiplexer circuit 13 to digital data and outputs the digital data.

Each input conversion circuit 11 receives information from current transformer 2 or voltage transformer 3, that is, the analog signal of the current waveform or the voltage waveform, converts the analog signal to an appropriate signal within merging unit 4, and thereafter outputs the converted signal to corresponding analog filter circuit 12. Each analog filter circuit 12 outputs a current signal or a voltage signal from corresponding input conversion circuit 11 to multiplexer circuit 13, after removing a high frequency component thereof.

Multiplexer circuit 13 has a plurality of input channels corresponding to the plurality of analog filter circuits 12. Multiplexer circuit 13 switches between the input channels in order at a prescribed cycle, according to a switching signal, and outputs an analog signal from one channel selected by switching to AD conversion circuit 14. Thereby, analog signals of the same number as the number of the input channels are converted to digital data in order.

AD conversion circuit 14 receives an analog signal (current or voltage waveform signal) and converts the received analog signal to digital data according to the sampling signal, and outputs the digital data to data processing unit 15.

The switching signal which determines a cycle at which multiplexer circuit 13 switches the input channels, and the sampling signal which determines the sampling cycle of AD conversion circuit 14 are provided from data processing unit 15 to multiplexer circuit 13 and AD conversion circuit 14, respectively.

Data processing unit 15 includes a first memory circuit 20 and a second memory circuit 24 which store the digital data of the current or the voltage from the input processing unit, and a sample rate conversion processing circuit 21 which performs prescribed processing on the digital data read from first memory circuit 20. Data processing unit 15 further includes a sampling signal generation circuit 23 for generating the switching signal for multiplexer circuit 13 and the sampling signal for AD conversion circuit 14, and a transmission formatting circuit 22. Transmission formatting circuit 22 converts the digital data subjected to the prescribed processing performed by sample rate conversion processing circuit 21, to transmission data according to a format of the prescribed protocol for indicating the state of the power system, and thereafter outputs the transmission data to the communication unit. Typically, transmission formatting circuit 22 edits serial data in which current signals or voltage signals collected from the power system are arranged in chronological order at every sampling cycle, according to the prescribed protocol, and outputs the edited serial data.

The communication unit includes an EO (Electrical-to-Optical) conversion circuit 16, a transmission/reception circuit 17 having an OE (Optical-to-Electrical) conversion function for receiving an accident detection signal from IED 5 or the like via station bus 9 and an EO conversion function for transmitting data to IED 5 or the like, and a reception circuit 18 which receives time synchronization signal 7. EO conversion circuit 16 is equivalent to a transmission processing unit for converting an electric signal as the digital data from transmission formatting circuit 22 to a light signal and thereafter transmitting the light signal to IED 5 via process bus 6.

In the present embodiment, a rate required for recording accidents (for example, 256f, where "f" is the system frequency) is adopted as the sample rate for AD conversion circuit 14. The sampling signal for the AD conversion is provided from sampling signal generation circuit 23 to AD conversion circuit 14. Sampling signal generation circuit 23 generates the switching signal for multiplexer circuit 13 and the sampling signal, from time synchronization signal 7 received by reception circuit 18, and outputs the generated signals to multiplexer circuit 13 and AD conversion circuit 14, respectively.

In data processing unit 15, chronological digital data output from AD conversion circuit 14 are written in first memory circuit 20, and data for a prescribed period are saved. First memory circuit 20 is a type of ring buffer having a storage capacity capable of storing at least the data for the prescribed period, and the data saved in the buffer for the prescribed period is updated sequentially, from older data, by overwriting with the digital data received from AD conversion circuit 14. That is, in the buffer, data is always saved for the prescribed period after being written, and thereafter is updated.

Sample rate conversion processing circuit 21 reads the digital data saved for the prescribed period from first memory circuit 20, converts the read data to data with a sample rate for protection control, and thereafter outputs the converted data to transmission formatting circuit 22. Transmission formatting circuit 22 generates serial data, from the digital data from sample rate conversion processing circuit 21, according to the protocol defined for process bus 6, and outputs the serial data to EO conversion circuit 16.

In addition, in data processing unit 15, the chronological digital data output from AD conversion circuit 14 are written in second memory circuit 24 and saved for a prescribed period, as with first memory circuit 20. Second memory circuit 24 is also a type of ring buffer, and latest data is always saved for the prescribed period. The data saved for the prescribed period is updated sequentially, from older data, by overwriting with the digital data from AD conversion circuit 14. The prescribed period for saving data in second memory circuit 24 may have a length different from the saving period in first memory circuit 20, and is generally a period of about several seconds to several tens of seconds.

When transmission/reception circuit 17 receives an accident detection signal from IED 5, transmission/reception circuit 17 outputs the signal to second memory circuit 24 in data processing unit 15. Second memory circuit 24 receives the accident detection signal from transmission/reception circuit 17, as trigger signal 10, and when second memory circuit 24 receives trigger signal 10, second memory circuit 24 stops data update by overwriting.

### (Sample Rate Conversion Processing)

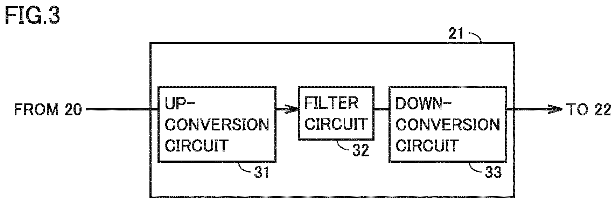

Fig. 3 is a block diagram of sample rate conversion processing circuit 21 in accordance with Embodiment 1 of the present invention. In the present embodiment, data based on a sample rate of 80f for system protection and data based on a sample rate of 256f for recording accident waveforms can be simultaneously collected by merging unit 4. Sample rate conversion processing circuit 21 is provided to collect the data based on the sample rate of 80f for system protection.

Referring to Fig. 3, sample rate conversion processing circuit 21 includes an up-conversion circuit 31, a filter circuit 32 as a digital filter for removing a high frequency component from received data, and a down-conversion circuit 33. These are cascade-connected in this order. Sample rate conversion processing circuit 21 converts data sampled at a sample rate for recording accidents (for example, 256f specified by IEC61850-9-2LE) to a sample rate for protection control (for example, 80f specified by IEC61850-9-2LE).

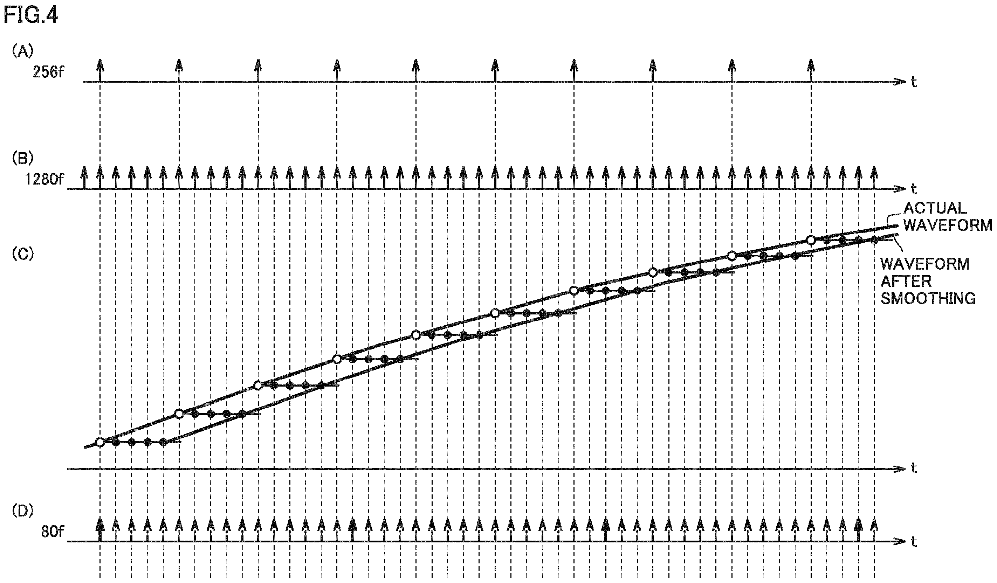

Fig. 4 is a view for illustrating sample rate conversion processing in accordance with Embodiment 1 of the present invention. Fig. 4 shows a case where sampling is performed using different sample rates, according to a common time axis t. (A), (B), and (D) in Fig. 4 schematically indicate the number of data (the number of samples) obtained when the same analog signal (a current signal or a voltage signal) is sampled at different sample rates of 256f, 1280f, and 80f, respectively, and cycles at which the data are obtained. (A) in Fig. 4 indicates timing of the data sampled at 256f output from AD conversion circuit 14, (B) in Fig. 4 indicates timing of data obtained by sampling the data for 256f indicated by (A) in Fig. 4, at 1280f, that is, timing of up-converted data, and (D) in Fig. 4 indicates timing of data obtained by sampling the data for 1280f indicated by (B) in Fig. 4, at 80f, that is, timing of down-converted data. (C) in Fig. 4 indicates plotting points (white round points) plotting a waveform sampled at the timing of (A) in Fig. 4, plotting points (black round points) indicating values of sample points (also referred to as sample values) obtained when up-conversion is performed as indicated by (B) in Fig. 4, and a waveform obtained after smoothing the above waveform. Referring to Fig. 4, an operation of sample rate conversion processing circuit 21 will be described.
(1) The data sampled at 256f by AD conversion circuit 14 (sample points indicated by arrows in (A) in Fig. 4) are saved in first memory circuit 20 for a prescribed period, and thereafter are output to up-conversion circuit 31.
(2) Up-conversion circuit 31 up-converts the received data for 256f for the prescribed period, to 1280f, which is the least common multiple of 256f and 80f, and thereafter outputs the up-converted data (sample points indicated by arrows in (B) in Fig. 4). In (C) in Fig. 4, of the points plotting a waveform after the up-conversion, points corresponding to the sample points for 256f are indicated by the white round points. In the present embodiment, the up-conversion is implemented by interpolating "M" sample points. Specifically, "M" is five, on the basis that 1280f after the up-conversion is equivalent to five times original 256f. In interpolation processing, interpolation is performed by interpolating, into a period from a sample value for 256f (referred to as a first sample value) to a next sample value for 256f (referred to as a second sample value), four values which are identical to the first sample value (the black round points in (C) in Fig. 4: also referred to as interpolation sample values), and thereby an original sample value for 256f is up-converted to 5 times the frequency (1280f). Up-conversion circuit 31 outputs the sample values in chronological order according to the sampling order, while attaching thereto an identifier which identifies whether each sample value is the first (second) sample value or an interpolation sample value.
(3) Filter circuit 32 is a type of digital LPF (Low Pass Filter) which removes a high frequency component. The step performed by filter circuit 32 includes a first step of smoothing the data for 1280f from up-conversion circuit 31, and a second step of performing anti-aliasing filtering. In the present embodiment, for the smoothing, for example, moving averaging is applied.
(3-1) In the moving averaging in the first step, filter circuit 32 calculates, for the data for 1280f received in chronological order from up-conversion circuit 31, an average value of a total of M sample values including the first (or second) sample value and the four interpolation sample values received subsequent thereto. Since the M sample values have an identical value, the average value obtained after interpolating the four values is identical to the original first (or second) sample value. Each interpolation sample value is interpolated between itself and one previous actual sample value for 256f, according to the number of interpolation sample values, that is, according to time. By such easy smoothing, the actual waveform after the up-conversion to 1280f is converted to the waveform after the smoothing (see (C) in Fig. 4).
(3-2) In the second step, filter circuit 32 performs anti-aliasing filtering suitable for the sample rate of 80f for protection control, on the chronological data for 1280f subjected to the smoothing, and thereafter outputs the data to down-conversion circuit 33. The anti-aliasing filtering is a filter which removes a high frequency component. More specifically, the anti-aliasing filtering is equivalent to low pass filtering which can cut a high frequency component more than or equal to a Nyquist frequency (40f), according to a sampling theorem (i.e., a high frequency component exceeding one half of a sampling frequency cannot be restored), based on the sample rate of 80f of down-conversion circuit 33 in a subsequent stage. Thereby, at the time of the down-conversion in the subsequent stage, sampling can be performed while suppressing loss of information.
(4) Down-conversion circuit 33 receives, from filter circuit 32, the chronological data for 1280f subjected to the smoothing and the anti-aliasing filtering. Down-conversion circuit 33 extracts sampling data, from the received chronological data, at timing indicated by thick arrows in (D) of Fig. 4, that is, one sampling data for every 16 sampling data (1280f/80f = 16), and outputs the extracted sampling data. Thereby, the data for 1280f are output to transmission formatting circuit 22, as chronological data for 80f decimated to one-sixteenth.

In the present embodiment, by using moving averaging for the computation of the smoothing, load on the computation can be reduced when compared with other computations (such as straight-line approximate computation, and approximate computation using a sine function). In addition, since the average value obtained by the smoothing includes the value identical to the original sample value for 256f (the first or second sample value), it is possible to include the original sample value for 256f in the chronological data for 80f to be output from subsequent down-conversion circuit 33. Thereby, accuracy of data for system protection to be transmitted to IED 5 or the like can be maintained, even if the sample rate is converted within merging unit 4.

It is noted that the prescribed period for which data is saved in first memory circuit 20 refers to a period for which the number of data more than or equal to the number required for the anti-aliasing filtering in (4) described above can be saved.

### (Recording of Accident Waveform Data)

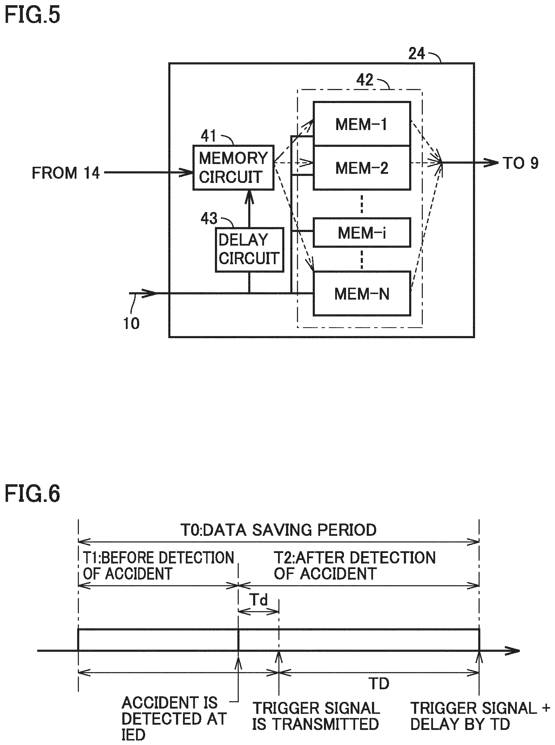

Fig. 5 is a block configuration diagram of second memory circuit 24 in accordance with Embodiment 1 of the present invention. Fig. 6 is a timing chart for illustrating an operation of second memory circuit 24 of Fig. 5.

Referring to Fig. 5, second memory circuit 24 includes a memory circuit 41 which stores data received in chronological order from AD conversion circuit 14, a failure recording/saving memory area 42 having N storage areas MEM-i (where i = 1, 2, 3, ... N) for accident recording data, and a delay circuit 43. When delay circuit 43 receives trigger signal 10 as an accident detection signal from IED 5, delay circuit 43 delays the received signal by a certain time, and thereafter outputs the delayed signal to memory circuit 41. Memory circuit 41 is a type of ring buffer. The chronological data from AD conversion circuit 14 are written in memory circuit 41, saved for a prescribed period, and thereafter read. An operation of second memory circuit 24 will be described.
(1) First, the data sampled at 256f from AD conversion circuit 14 are stored in memory circuit 41 in order, according to the chronological order. In memory circuit 41, the data for the prescribed period counted back from the latest stored data are saved. Whenever data (equivalent to the latest data) is output from AD conversion circuit 14, the oldest data of the data for the prescribed period is updated by being overwritten with the latest data.
(2) When delay circuit 43 receives trigger signal 10, delay circuit 43 delays trigger signal 10 by a set time TD, and thereafter outputs trigger signal 10 to memory circuit 41 and failure recording/saving memory area 42. When memory circuit 41 receives trigger signal 10 from delay circuit 43, memory circuit 41 stops the update described above. The data for the prescribed period in memory circuit 41 which stops the update are transferred to failure recording/saving memory area 42, and the transferred data are stored in a storage area MEM-1, in chronological order, together with the time data of trigger signal 10. After storing the data, writing into memory circuit 41 is started again, and preparation is made for stopping of the update by a next trigger signal and transferring (to MEM-2). In the example of Fig. 5, this data saving by the trigger signal is configured such that data can be saved up to N times, from MEM-1 to MEM-N.
(3) When second memory circuit 24 receives a requst from corresponding IED 5 or substation automation system 8 at a higher level via station bus 9 and transmission/reception circuit 17, second memory circuit 24 reads data from failure recording/saving memory area 42, and transmits the read data to requesting IED 5 or substation automation system 8 via transmission/reception circuit 17. IED 5 or substation automation system 8 receives the data in failure recording/saving memory area 42, from merging unit 4. Using the received data, IED 5 or substation automation system 8 can analyze accident recording data.

Set time TD for delay circuit 43 will be described with reference to Fig. 6. It is defined that a transmission time from when IED 5 connected to merging unit 4 detects an accident to when trigger signal 10 for recording an accident (that is, an accident detection signal) is transmitted to merging unit 4 is a time Td, and waveform data required for analyzing the accident is waveform data for a period of a time T1 before the detection of the accident and a period of a time T2 after the detection of the accident. In this case, set time TD is expressed as TD = T2-Td, from Fig. 6. That is, memory circuit 41 is required to have a capacity capable of storing (saving) the waveform data for T0 = T1+T2.

As described above, since trigger signal 10 received by merging unit 4 is delayed by set time TD and thereafter provided to memory circuit 41, in a case where an accident is detected, the update of memory circuit 41 can be stopped when the waveform data for the time required for analyzing the accident, that is, the waveform data equivalent to prescribed period T0, is stored. Thereby, the waveform data can be saved in memory circuit 41 over prescribed period T0 consisting of the periods before and after the detection of the accident. According to the configuration in Fig. 5, N waveform data, that is, waveform data representing phenomena at the time of accidents respectively equivalent to N trigger signals 10, can be saved.

In merging unit 4 in accordance with the present embodiment, an analog signal of the current or the voltage from the power system is sampled at a sample rate for recording accidents (256f) and converted to digital data, and the converted digital data is stored in first memory circuit 20 and second memory circuit 24. In the case where an accident is detected, accident recording data for 256f can be saved in second memory circuit 24 by trigger signal 10, over prescribed period T0 before and after the detection of the accident, as shown in Fig. 6. On the other hand, the data with the sample rate for recording accidents (256f) read from first memory circuit 20 is converted by sample rate conversion processing circuit 21, to a sample rate for protection control (80f). Then, the converted data is transmitted onto process bus 6 via transmission formatting circuit 22.

Therefore, single merging unit 4 can have both a function of transmitting the data with the sample rate for protection control onto process bus 6, and a function of storing (saving) the data with the sample rate for recording accidents in an internal memory. Thereby, it is not necessary to install a merging unit for protection control and additionally install a merging unit for recording accidents. Further, in a case where a merging unit for recording accidents is provided individually, it is necessary to transmit data from a plurality of merging units to an IED for recording accidents with a high sample rate. Therefore, it is necessary to increase transmission speed. However, according to the present embodiment, since merging unit 4 has the function of storing (saving) the data with the sample rate for recording accidents in the internal memory, the above necessities are eliminated, and therefore, protection control system 100 can be configured at low cost.

### [Reference example 1]

In Reference example 1, another example of a configuration of a merging unit applied to protection control system 100 will be illustrated. Other than a merging unit 4A, components of protection control system 100 are identical to those in Embodiment 1 shown in Fig. 1.

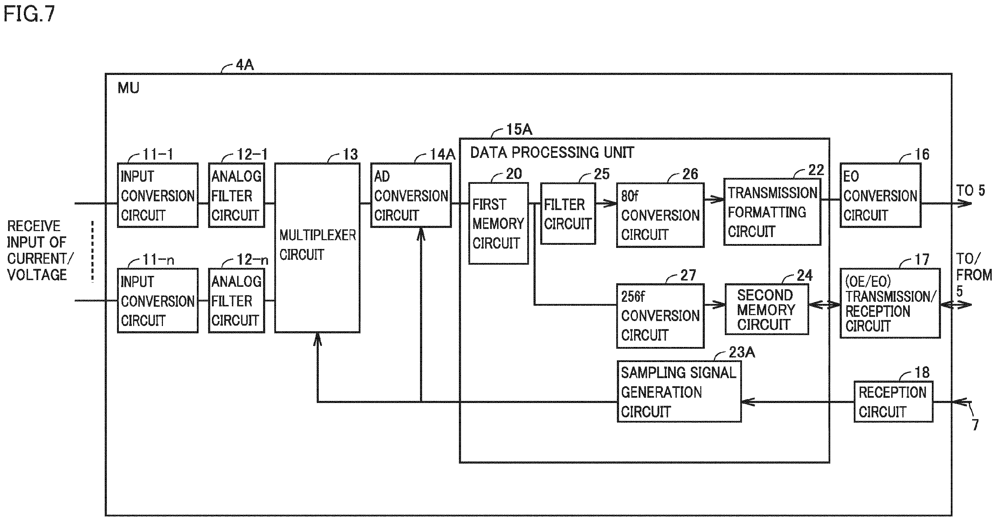

Fig. 7 is a configuration diagram of merging unit 4A in accordance with Reference example 1 not encompassed by the wording of the claims but useful in understanding the present disclosure. Differences between merging unit 4A of Fig. 7 and merging unit 4 of Fig. 2 are that merging unit 4A includes an AD conversion circuit 14A instead of AD conversion circuit 14 in Fig. 2, and includes a data processing unit 15A instead of data processing unit 15 in Fig. 2. Since other components of merging unit 4A are identical to those of merging unit 4, a description will now be given, focusing on the differences. AD conversion circuit 14A generates two types of data, for recording accidents and for protection control, by down-sampling (decimating) data obtained by performing sampling at the least common multiple of the sample rate for recording accidents and the sample rate for protection control and performing AD conversion. This provides an advantage that the smoothing at the time of the up-conversion in Embodiment 1 can be eliminated.

In operation, AD conversion circuit 14A receives current signals or voltage signals (analog signals) collected from a power system via multiplexer circuit 13, samples the received signals, and thereby converts the received signals into chronological digital data and outputs the digital data. The switching signal which determines a cycle at which multiplexer circuit 13 switches the received channels, and a sampling signal which determines the sampling cycle of AD conversion circuit 14 are provided from data processing unit 15A. The sampling signal provided to AD conversion circuit 14A is a sampling signal having a sample rate of the least common multiple (1280f) of the sample rate for recording accidents (256f) and the sample rate for protection control (80f).

Data processing unit 15A receives the data from AD conversion circuit 14A, and stores the received data in first memory circuit 20. The chronological data read from first memory circuit 20 are output to a filter circuit 25 and a 256f conversion circuit 27.

Filter circuit 25 performs anti-aliasing filtering on the data for 1280f from first memory circuit 20, and outputs the data to an 80f conversion circuit 26. In the anti-aliasing filtering by filter circuit 25, low pass filtering is performed as in Embodiment 1, which removes data of a frequency component more than or equal to the Nyquist frequency of 40f, considering that 80f conversion circuit 26 in a subsequent stage has a sample rate of 80f.

80f conversion circuit 26 converts the received data for 1280f to chronological data for 80f decimated to one-sixteenth, and thereafter outputs the converted data to transmission formatting circuit 22. Thereby, the data with the sample rate for protection control is transmitted onto process bus 6.

On the other hand, 256f conversion circuit 27 receives the chronological data for 1280f from first memory circuit 20, and performs 256f conversion by decimation which extracts one sample value for every five sample values for 1280f. The sample values output from 256f conversion circuit 27 are stored in second memory circuit 24 according to the chronological order. Thereby, accident recording data for 256f can be saved in second memory circuit 24. In a case where second memory circuit 24 receives trigger signal 10 when an accident is detected, second memory circuit 24 can stop the update of memory circuit 41 and save data when the waveform data for the time required for analyzing the accident, that is, the waveform data equivalent to prescribed period T0, is stored, as in Embodiment 1.

In Fig. 7, the high frequency component which should be removed for the conversion to 256f by 256f conversion circuit 27 is removed beforehand by filter circuits 12, by setting an appropriate cut-off frequency for filter circuits 12. Accordingly, although filter circuit 25 is provided in a preceding stage of 80f conversion circuit 26, it is not necessary to provide a filter circuit for removing a high frequency component in a preceding stage of 256f conversion circuit 27. It is noted that, if characteristics (cut-off frequency) of filter circuits 12 have characteristics of an anti-aliasing filter for 1280f, filter circuits 12 may fail to remove a high frequency component which exerts influence at the time of the conversion to 256f. In that case, it is necessary to provide a filter circuit having characteristics of an anti-aliasing filter for 256f, in the preceding stage of 256f conversion circuit 27.

According to Reference example 1, since frequency conversion is only down-conversion from 1280f to 80f and from 1280f to 256f, processing for up-conversion is not required when compared with Embodiment 1, and processing is simplified accordingly.

Sample rate conversion in Embodiment 1, in summary, adopts a method in which, when the sample rate is converted from 256f to 80f, data is up-converted to a sample rate of 1280f, which is the least common multiple of 256f and 80f, and the data is down-converted by decimation. As the up-conversion, the data is interpolated to be data for 1280f by continuing an original sample value for 256f to a next sample value for 256f (that is, latching the data until it is updated with the next sample value for 256f). Thereafter, noise is removed by moving-averaging the five values (where five is obtained from 5 = (1280f/256t)). In addition, at the time of the down-conversion, moving-averaged data is converted to data for 80f by first removing therefrom a frequency component exceeding 80f via an anti-aliasing filter having frequency characteristics of the Nyquist frequency, and thereafter decimating the data to one-sixteenth, and the converted data is transmitted.

In Reference example 1, in summary, data is converted to digital data with a sample rate of 1280f, which is the least common multiple of 256f and 80f, at the time of AD conversion. In merging unit 4A, the AD-converted digital data for 1280f is converted to data for 256f by decimation, and is saved for recording an accident (stored in second memory circuit 24). Further, the AD-converted digital data for 1280f is converted to data for 80f for protection control, by removing therefrom a high frequency component via the anti-aliasing filter having the Nyquist frequency as frequency characteristics, and thereafter decimating the data, and the converted data is transmitted.

### (Variation)

In Embodiment 1 or Reference example 1, IED 5 or the like may be configured to transmit an accident detection signal to merging unit 4 (4A), when it determines that, for example, data with the sample rate for protection control (80f) received from merging unit 4 (4A) satisfies a condition such as a predetermined relay computation logic.

Further, although merging unit 4 or 4A is configured to receive an accident detection signal via station bus 9 in Embodiment 1 or Reference example 1, merging unit 4 or 4A may be configured to receive an accident detection signal via process bus 6 instead of station bus 9.

Further, although IED 5 or substation automation system 8 requests data saved in second memory circuit 24 in Embodiment 1 or Reference example 1, a request destination is not limited to single merging unit 4 (4A). For example, in a case where IED 5 or substation automation system 8 requests data saved in second memory circuits 24 of a plurality of merging units 4 (4A), IED 5 or substation automation system 8 may transmit a request to each of the plurality of merging units 4 (4A) such that the data can be read from memories in any time order. This avoids transmission data from concentrating onto process bus 6 at once, and can suppress an increase in communication load due to increased traffic.

### (Effects of Embodiment)

According to the embodiment, in merging unit 4, current/voltage information as power system information is always AD-converted with the sample rate for recording failures (256f). Of the AD-converted data as described above, data for prescribed period T0 extending before and after the reception of trigger signal 10 as an accident detection signal from IED 5 or the like can be saved in second memory circuit 24. Further, by providing a sample rate conversion circuit and a filter circuit, data with the sample rate for protection control (80f) can be obtained from the data AD-converted with the sample rate for recording failures (256f).

In addition, merging unit 4 can also be used as a merging unit for recording accidents, although merging unit 4 does not have a function of recording accidents in real time. That is, since second memory circuit 24 can provide the function of saving data for recording accidents, data can be read from second memory circuit 24 and transmitted to process bus 6 by utilizing a function of always transmitting data to process bus 6 in real time provided by merging unit 4. On this occasion, if transmission efficiency for the sample rate for protection control (80f) is reduced when data are transmitted at once, in particular, adverse effects on the traffic in process bus 6 can be prevented by transmitting the data in a divided manner. Thereby, merging unit 4 can also be used as a merging unit for recording accidents. As a result, costs for the merging unit and protection control system 100 including the same can be reduced. Further, since data can be read from second memory circuits 24 and transmitted from a related plurality of merging units 4 in any time order, in response to a request from IED 5, substation automation system 8 at a higher level, or the like, data can be transmitted while avoiding an increase in traffic.

It should be understood that the embodiment and reference example disclosed herein are illustrative and non-restrictive in every respect. The scope of the present invention is defined by the scope of the claims, rather than the description above, and is intended to include any modifications within the scope of said claims.

### REFERENCE SIGNS LIST

1: power line; 2: current transformer; 3: voltage transformer; 4, 4A: merging unit; 5: IED; 6: process bus; 7: time synchronization signal; 8: substation automation system; 9: station bus; 10: trigger signal; 13: multiplexer circuit; 14, 14A: AD conversion circuit; 15, 15A: data processing unit; 20: first memory circuit; 21: sample rate conversion processing circuit; 22: transmission formatting circuit; 23: sampling signal generation circuit; 24: second memory circuit; 31: up-conversion circuit; 33: down-conversion circuit; 41: memory circuit; 42: failure recording/saving memory area; 43: delay circuit; 100: protection control system.

## Claims

1. A merging unit (4) configured to collect information of at least current or voltage from a power system, comprising:
a processing unit configured to process an analog signal obtained from said power system and to output digital data indicating a state of the power system; and
a communication unit configured to communicate with an external device (5, 8) via a communication line, wherein said processing unit includes
a first conversion unit (14) configured to convert an analog signal of the current or the voltage of said power system to digital data with a first sample rate, and a second conversion unit (21) configured to convert the digital data with said first sample rate received from said first conversion unit to digital data with a second sample rate lower than said first sample rate, wherein the first sample rate is not an integer multiple of the second sample rate, wherein the second conversion unit comprises; an up-conversion unit (31) configured to convert the digital data with said first sample rate received from said first conversion unit to digital data with a sample rate of a least common multiple of said first sample rate and a second sample rate, and a down-conversion unit (33) configured to receive the digital data converted by said up-conversion unit and to convert the received digital data to the digital data with said second sample rate, wherein
said up-conversion unit has an interpolation unit configured to interpolate the digital data with said first sample rate from said first conversion unit, by N1 times, where N1 = the sample rate of said least common multiple divided by said first sample rate, by inserting, between a sample value and a next sample value, data identical to one of the sample values, and
said processing unit is configured to store the digital data with said first sample rate converted by said first conversion unit, over a prescribed period which is based on timing at which said merging unit receives a prescribed signal via said communication unit, and to transmit the digital data with said second sample rate converted by said second conversion unit, via said communication unit.

2. The merging unit according to claim 1, wherein said second conversion unit further has a filter unit (32) configured to smooth the digital data interpolated by said interpolation unit by performing moving averaging for every N1 data, and to output the smoothed digital data to said down-conversion unit after removing, from the smoothed digital data, data corresponding to a frequency component more than or equal to a Nyquist frequency based on said second sample rate.

3. A protection control system comprising the merging unit, the external device (5) and the communication line according to claim 1 wherein, when said external device determines that the digital data with said second sample rate received via said communication line satisfies a predetermined condition thereby detecting an abnormality in the power system, said external device is configured to transmit said prescribed signal to said merging unit.

## Patentansprüche

1. Zusammenführungseinheit (4), die dazu ausgelegt ist, Informationen über zumindest Strom oder Spannung von einem Leistungssystem zu sammeln, umfassend:
eine Verarbeitungseinheit, die dazu ausgelegt ist, ein analoges Signal, das von dem Leistungssystem erhalten wurde, zu verarbeiten und digitale Daten, die einen Zustand des Leistungssystems angeben, auszugeben; und
eine Kommunikationseinheit, die dazu ausgelegt ist, mit einer externen Vorrichtung (5, 8) über eine Kommunikationsleitung zu kommunizieren, wobei
die Verarbeitungseinheit Folgendes umfasst:
eine erste Umwandlungseinheit (14), die dazu ausgelegt ist, ein analoges Signal des Stroms oder der Spannung des Leistungssystems in digitale Daten mit einer ersten Abtastrate umzuwandeln, und eine zweite Umwandlungseinheit (21), die dazu ausgelegt ist, die digitalen Daten mit der ersten Abtastrate, die von der ersten Umwandlungseinheit empfangen wurden, in digitale Daten mit einer zweiten Abtastrate, die geringer ist als die erste Abtastrate, umzuwandeln, wobei die erste Abtastrate kein ganzzahliges Vielfaches der zweiten Abtastrate ist, wobei die zweite Umwandlungseinheit Folgendes umfasst:
eine Aufwärtsumwandlungseinheit (31), die dazu ausgelegt ist, die digitalen Daten mit der ersten Abtastrate, die von der ersten Umwandlungseinheit empfangen wurden, in digitale Daten mit einer Abtastrate von zumindest einem gemeinsamen Vielfachen der ersten Abtastrate und einer zweiten Abtastrate umzuwandeln, und
eine Abwärtsumwandlungseinheit (33), die dazu ausgelegt ist, die digitalen Daten, die von der Aufwärtsumwandlungseinheit umgewandelt wurden, zu empfangen und die empfangenen digitalen Daten in die Daten mit der zweiten Abtastrate umzuwandeln, wobei
die Aufwärtsumwandlungseinheit eine Interpolationseinheit aufweist, die dazu ausgelegt ist, die digitalen Daten mit der ersten Abtastrate von der ersten Umwandlungseinheit durch Einsetzen von Daten zwischen einem Abtastwert und einem nächsten Abtastwert, die mit einem der Abtastwerte identisch sind, N1-mal zu interpolieren, wobei N1 die Abtastrate des zumindest einen gemeinsamen Vielfachen dividiert durch die erste Abtastrate ist, und wobei
die Verarbeitungseinheit dazu ausgelegt ist, die digitalen Daten mit der ersten Abtastrate, die von der ersten Umwandlungseinheit umgewandelt wurden, über eine vorgeschriebene Zeitspanne, die auf einem Zeitpunkt beruht, an dem die Zusammenführungseinheit über die Kommunikationseinheit ein vorgeschriebenes Signal empfängt, zu speichern und die digitalen Daten mit der zweiten Abtastrate, die von der zweiten Umwandlungseinheit umgewandelt wurden, über die Kommunikationseinheit zu übertragen.

2. Zusammenführungseinheit nach Anspruch 1, wobei die zweite Umwandlungseinheit ferner eine Filtereinheit (32) umfasst, die dazu ausgelegt ist, die digitalen Daten, die von der Interpolationseinheit interpoliert werden, durch Durchführen eines gleitenden Mittelwerts für alle N1-Daten zu glätten und die geglätteten digitalen Daten an die Abwärtsumwandlungseinheit auszugeben, nachdem aus den geglätteten digitalen Daten Daten entfernt wurden, die einer Frequenzkomponente von größer oder gleich einer Nyquist-Frequenz beruhend auf der zweiten Abtastrate entsprechen.

3. Schutzsteuerungssystem, umfassend eine Zusammenführungseinheit, eine externe Vorrichtung (5) und eine Kommunikationsleitung nach Anspruch 1, wobei, wenn die externe Vorrichtung bestimmt, dass die digitalen Daten mit der zweiten Abtastrate, die über die Kommunikationsleitung empfangen wurden, eine vorbestimmte Bedingung erfüllen, durch die eine Anomalie im Leistungssystem detektiert wird, die externe Vorrichtung dazu ausgelegt ist, das vorgeschriebene Signal an die Zusammenführungseinheit zu übertragen.

## Revendications

1. Unité de fusion (4) configurée pour collecter des informations d'au moins un courant ou une tension à partir d'un système d'alimentation, comprenant :
une unité de traitement configurée pour traiter un signal analogique obtenu à partir dudit système d'alimentation et pour délivrer en sortie des données numériques indiquant un état du système d'alimentation ; et
une unité de communication configurée pour communiquer avec un dispositif externe (5, 8) via une ligne de communication, dans laquelle
ladite unité de traitement inclut
une première unité de conversion (14) configurée pour convertir un signal analogique du courant ou de la tension dudit système d'alimentation en données numériques avec une première fréquence d'échantillonnage, et une seconde unité de conversion (21) configurée pour convertir les données numériques avec ladite première fréquence d'échantillonnage reçues de ladite première unité de conversion en données numériques avec une seconde fréquence d'échantillonnage inférieure à ladite première fréquence d'échantillonnage, dans laquelle la première fréquence d'échantillonnage n'est pas un multiple entier de la seconde fréquence d'échantillonnage, dans laquelle la seconde unité de conversion comprend ; une unité de conversion ascendante (31) configurée pour convertir les données numériques avec ladite première fréquence d'échantillonnage reçues de ladite première unité de conversion en données numériques avec une fréquence d'échantillonnage d'un plus petit multiple commun de ladite première fréquence d'échantillonnage et d'une seconde fréquence d'échantillonnage, et une unité de conversion descendante (33) configurée pour recevoir les données numériques converties par ladite unité de conversion ascendante et pour convertir les données numériques reçues en données numériques avec ladite seconde fréquence d'échantillonnage, dans laquelle
ladite unité de conversion ascendante présente une unité d'interpolation configurée pour interpoler les données numériques avec ladite première fréquence d'échantillonnage provenant de ladite première unité de conversion, par N1 fois, où N1 = la fréquence d'échantillonnage dudit plus petit multiple commun divisée par ladite première fréquence d'échantillonnage, en insérant, entre une valeur d'échantillonnage et une valeur d'échantillonnage suivante, des données identiques à l'une des valeurs d'échantillonnage, et
ladite unité de traitement est configurée pour stocker les données numériques avec ladite première fréquence d'échantillonnage converties par ladite première unité de conversion, sur une période prescrite qui est basée sur une synchronisation à laquelle ladite unité de fusion reçoit un signal prescrit via ladite unité de communication, et pour transmettre les données numériques avec ladite seconde fréquence d'échantillonnage converties par ladite seconde unité de conversion, via ladite unité de communication.

2. Unité de fusion selon la revendication 1, dans laquelle ladite seconde unité de conversion présente en outre une unité de filtre (32) configurée pour lisser les données numériques interpolées par ladite unité d'interpolation en effectuant un moyennage mobile pour toutes les N1 données, et pour délivrer en sortie les données numériques lissées vers ladite unité de conversion descendante après avoir retiré, des données numériques lissées, des données correspondant à une composante de fréquence supérieure ou égale à une fréquence de Nyquist sur la base de ladite seconde fréquence d'échantillonnage.

3. Système de commande de protection comprenant l'unité de fusion, le dispositif externe (5) et la ligne de communication selon la revendication 1, dans lequel, lorsque ledit dispositif externe détermine que les données numériques avec ladite seconde fréquence d'échantillonnage reçues via ladite ligne de communication satisfont à une condition prédéterminée, en détectant ainsi une anomalie dans le système d'alimentation, ledit dispositif externe est configuré pour transmettre ledit signal prescrit à ladite unité de fusion.
